# EUROPEAN PATENT APPLICATION

(11) **EP 4 697 868 A1**
(43) Date of publication of application: **18.02.2026**
(21) Application number: 23935977.1
(22) Date of filing: 08.05.2023
(51) Int. Cl.: H05K 1/18, H05K 1/14, H05K 1/00, H01L 23/52, H01L 25/16

(54) **CIRCUIT BOARD ASSEMBLY AND ELECTRONIC DEVICE**

(71) Applicant: Huawei Digital Power Technologies Co., Ltd., Shenzhen, Guangdong 518043 (CN)
(72) Inventor: WU, Yukun, Shenzhen, Guangdong 518043 (CN); ZHANG, Lihui, Shenzhen, Guangdong 518043 (CN); LIN, Tianren, Shenzhen, Guangdong 518043 (CN); HOU, Xuebing, Shenzhen, Guangdong 518043 (CN)
(74) Representative: Maiwald GmbH
(86) International application number: PCT/CN2023/092718
(87) International publication number: WO 2024/229648

(57) **Abstract**

This application discloses a circuit board assembly and an electronic device. The circuit board assembly includes a first substrate, a second substrate, a chip, and a first power module. The first substrate and the second substrate are disposed opposite to each other and at an interval. A power supply component and a conductive member are disposed on a first surface that is of the first substrate and that faces the second substrate, and the power supply component is electrically connected to the conductive member. The chip is disposed on a first surface that is of the second substrate and that faces away from the first substrate, and the first power module is disposed on a second surface that is of the second substrate and that faces the first substrate. An input terminal is disposed on a surface that is of the first power module and that faces the first substrate, and the input terminal is electrically connected to the conductive member. An output terminal is disposed on a first surface that is of the first power module and that faces the second substrate, and the output terminal is electrically connected to the chip. The first power module is configured to perform regulating and filtering on a voltage input by the input terminal, and then output a voltage to the output terminal.

## Description

### TECHNICAL FIELD

This application relates to the field of electronic device technologies, and in particular, to a circuit board assembly and an electronic device.

### BACKGROUND

As digital and intelligent levels of the information society improve continuously, an existing computing power infrastructure is mainly provided in a form of data center to implement high-performance computing power supply. High computing power chips are specific carriers of computing power. Advanced high computing power chips and dedicated artificial intelligence (artificial intelligence, AI) processors are driving rapid development of AI.

Currently, the high computing power chip is provided with tens of billions of transistors, bringing exponential growth in power supply requirements while improving performance. Power supply has become a limiting factor for improvement of computing performance of the chip. In an existing power supply solution for a chip, a problem of current imbalance exists in a power supply link in a power delivery network (power delivery network, PDN). In addition, because the power supply link is long, it is difficult to greatly reduce impedance, and also difficult to reduce inductance. As a result, a rate of current change of the chip is large, causing voltage fluctuation of a power supply pin of the chip. Such transient voltage fluctuation causes problems in transient performance and power consumption of a processor, and the like.

### SUMMARY

This application provides a circuit board assembly and an electronic device, to improve current balance of a power supply link of the circuit board assembly, shorten a path length of the power supply link, and improve performance of the electronic device.

According to a first aspect, this application provides a circuit board assembly, and the circuit board assembly includes a first substrate, a second substrate, a chip, and a first power module. The first substrate and the second substrate are disposed opposite to each other and at an interval. The first substrate includes a first surface facing the second substrate, a power supply component and a conductive member are disposed on the first surface of the first substrate, and the power supply component is electrically connected to the conductive member. The second substrate includes a first surface facing away from the first substrate and a second surface facing the first substrate. The chip is disposed on the first surface of the second substrate, and the first power module is disposed on the second surface of the second substrate. An input terminal is disposed on a surface that is of the first power module and that faces the first substrate, and the input terminal may be electrically connected to the conductive member. An output terminal is disposed on a first surface that is of the first power module and that faces the second substrate, and the output terminal may be electrically connected to the chip. The first power module may be configured to perform regulating and filtering on a voltage input by the input terminal, and then output a voltage to the output terminal.

In this application, the power supply component and the chip are disposed on different substrates, and the input terminal and the output terminal of the first power module are located on two opposite surfaces of the first power module, to implement a solution of vertically supplying power to the chip. This power supply solution can avoid a problem of different lengths of power supply links to some extent, and can effectively shorten a path length of the power supply link, to reduce impedance and inductance of the power supply link, reduce a circuit board loss and voltage fluctuation, and help improve performance of the electronic device.

In some implementation solutions, the first power module may include a voltage regulator module and one or more filter capacitors, and the voltage regulator module and the one or more filter capacitors may be packaged into an integrated structure. The voltage regulator module is configured to regulate the voltage input by the input terminal, and then output a voltage to the filter capacitor, so that the regulated voltage can match an operating voltage of the chip. The filter capacitor is configured to perform filtering on the voltage output by the voltage regulator, and then output a voltage to the output terminal, to improve stability of the voltage output by the first power module to the chip.

For example, the voltage regulator module and the filter capacitor may be packaged into an integrated structure through ball grid array packaging.

In some implementation solutions, the conductive member is an elastic conductive member, and the conductive member elastically abuts against the input terminal of the first power module, to implement an electrical connection to the input terminal. The conductive member is designed as an elastic structure. In this way, when there are a plurality of first power modules, different deformation forms of a plurality of corresponding conductive members may be used to compensate for tolerances between the first power modules, so that an input terminal of each first power module can be electrically connected to a corresponding conductive member reliably.

For example, the conductive member includes a spring plate, a spring ejector pin, a conductive adhesive layer, or the like.

In some implementation solutions, the circuit board assembly may further include a support member, the support member is disposed between the first substrate and the second substrate, and a height of the support member is less than a sum of a height of the conductive member in an energy-release state and a height of the first power module. With the use of such a design, the conductive member can be in a compressed and energy-storage state, and a risk of over-compression of the conductive member can be lowered through limiting of the support member. This improves reliability of a structure of the conductive member, and improves reliability of an electrical connection between the conductive member and the input terminal of the first power module.

In some implementation solutions, the first substrate is provided with a first installation hole, the second substrate is provided with a second installation hole opposite to the first installation hole, and the first substrate and the second substrate may be fastened relative to each other by using a fastener that is installed in the first installation hole and the second installation hole.

In an implementation, a nut matching the fastener may be fastened to a position that is on the first surface of the second substrate and that corresponds to the first installation hole, and an end part of the fastener may be locked in the nut, so that the first substrate and the second substrate are fastened.

In some implementation solutions, the power supply component may include a power supply terminal and a second power module, an input end of the second power module is electrically connected to the power supply terminal, and an output end of the second power module is electrically connected to the conductive member. The second power module may be configured to regulate a voltage provided by the power supply terminal, and then output a voltage to the conductive member, so that the voltage is output to the first power module through the conductive member.

In some implementation solutions, the power supply component is the power supply terminal, and the power supply terminal is electrically connected to the conductive member.

In some implementation solutions, the first substrate includes a circuit board and a metal plate, the circuit board and the metal plate are disposed in a stacked manner, and a surface that is of the circuit board and that is away from the metal plate may be used as the first surface of the first substrate. The first substrate in this form has a good heat-conducting property, and can quickly dissipate heat generated by the first substrate and an electronic component disposed on the first substrate to the outside.

In some implementation solutions, the circuit board assembly further includes a first heat sink, the first heat sink is disposed on a surface that is of the first substrate and that is away from the second substrate, and the first heat sink is in heat-conducting contact with the first substrate. After heat generated when the electronic component on the first substrate operates is transferred to the first substrate, the first substrate may transfer the heat to the first heat sink, and the first heat sink transfers the heat to the outside, to implement heat dissipation and cooling of the first substrate and the electronic component disposed on the first substrate.

In a specific implementation, the first heat sink may be fastened, through welding, to the surface that is of the first substrate and that is away from the second substrate.

In a specific implementation, the first heat sink may be a heat pipe. The heat pipe can dissipate heat for the first substrate, and implement a function of equalizing temperature, to improve temperature consistency between regions of the first substrate, and implement balanced heat dissipation effect for the first substrate and the electronic component disposed on the first substrate.

In some implementation solutions, the circuit board assembly further includes a second heat sink, the second heat sink is disposed on a surface that is of the chip and that is away from the second substrate, and the second heat sink is in heat-conducting contact with the chip. In this way, heat generated in an operating process of the chip may be transferred to the second heat sink, and transferred to the outside through the second heat sink, to implement heat dissipation and cooling of the chip.

In a specific implementation, the second heat sink may be a liquid-cooled plate. The liquid-cooled plate can continuously transfer, through circulation of a cooling medium inside the liquid-cooled plate, heat generated by the chip to the outside, to implement continuous heat dissipation of the chip.

According to a second aspect, this application further provides an electronic device. The electronic device includes a housing and the circuit board assembly in any one of the implementation solutions provided in the first aspect, and the circuit board assembly is disposed in the housing. Because a length of a power supply link for the chip in the circuit board assembly is shortened, a circuit board loss and voltage fluctuation are reduced, and performance of the electronic device is improved.

### BRIEF DESCRIPTION OF DRAWINGS

FIG. 1 is a schematic diagram of a structure of an electronic device according to an embodiment of this application;
FIG. 2 is a side view of a circuit board assembly 300 according to an embodiment of this application;
FIG. 3 is a schematic diagram of a structure of a first power module 340 according to an embodiment of this application; and
FIG. 4 is a schematic diagram of a structure of another circuit board assembly according to an embodiment of this application.

### Reference numerals:

In a conventional technology,
100: housing; 200: circuit board; 210: chip; 220: power supply component;
In embodiments of this application,
100: housing; 300: circuit board assembly; 310: first substrate; 310a: first surface of the first substrate; 311: circuit board;
312: metal plate; 320: second substrate; 320a: first surface of the second substrate; 320b: second surface of the second substrate;
330: chip; 340: first power module; 341: input terminal; 342: output terminal; 343: voltage regulator module;
344: filter capacitor; 350: power supply component; 351: power supply terminal; 352: second power module; 360: conductive member;
370: support member; 380: first heat sink; 381: evaporation section; 382: condensation section; 390: second heat sink.

### DESCRIPTION OF EMBODIMENTS

To make objectives, technical solutions, and advantages of this application clearer, the following further describes this application in detail with reference to accompanying drawings. However, example implementations can be implemented in a plurality of forms, and shall not be construed as being limited to implementations described herein. Identical reference numerals in the accompanying drawings represent identical or similar structures. Therefore, repeated description thereof is omitted. Expressions of positions and directions in embodiments of this application are described by using the accompanying drawings as an example. However, changes may be made as required, and all the changes fall within the protection scope of this application. The accompanying drawings in embodiments of this application are merely used to illustrate relative position relationships and do not represent an actual scale.

It should be noted that, specific details are described in the following descriptions for ease of understanding of this application. However, this application can be implemented in a plurality of manners different from those described herein, and a person skilled in the art can perform similar promotion without departing from the connotation of this application. Therefore, this application is not limited to the specific implementations disclosed below.

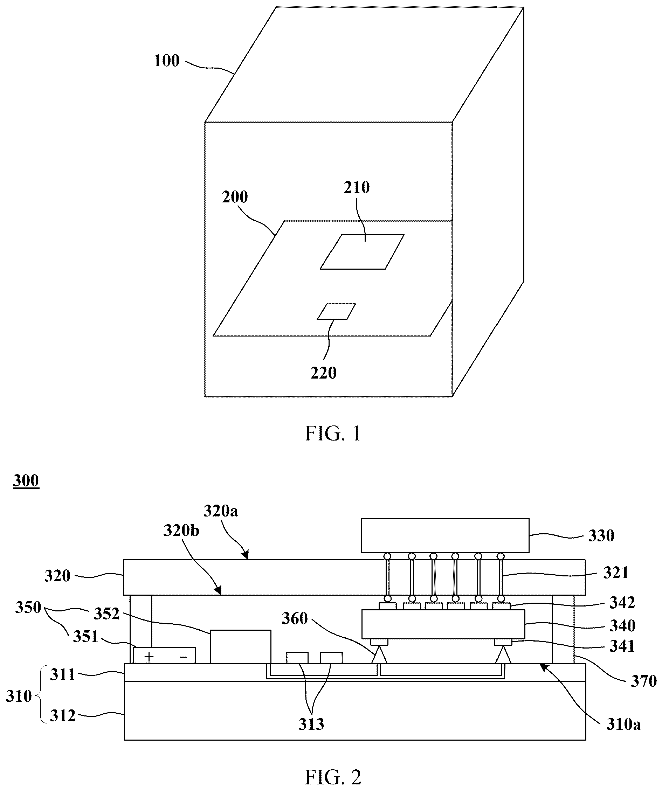

FIG. 1 is a schematic diagram of a structure of an electronic device according to an embodiment of this application. Refer to FIG. 1. In this embodiment of this application, the electronic device may be a computer device having a processor chip, for example, a server, a desktop computer, or a personal computer, or may be a portable electronic device having a processor, for example, a mobile phone, a tablet computer, or a vehicle-mounted device. In this embodiment of this application, an example in which the electronic device is a server is used for description.

The electronic device may include a housing 100 and a circuit board 200. The circuit board 200 is disposed in the housing 100, and a chip 210 is disposed on the circuit board 200. In addition to the chip 210, a power supply component 220 and another electronic component may be further disposed on the circuit board 200, and the power supply component may be configured to provide electric energy for the chip 210 and the another electronic component. In this embodiment, the chip 210 may be a graphics processing unit (graphics processing unit, GPU), or may be a chip having a logical operation capability such as a central processing unit (central processing unit, CPU) or a system on chip (system on chip, SoC), or may be an application-specific integrated circuit (application-specific integrated circuit, ASIC) of another type, a programmable logic device such as a field programmable gate array (field programmable gate array, FPGA), a transistor logic device, a hardware component, or any combination thereof.

For example, an existing GPU has tens of billions of transistors, bringing exponential growth in power supply requirements while improving performance. Power supply has become a limiting factor for improvement of computing performance of the GPU. Because a size and power consumption of the chip increase, lengths of power supply links between power supply pins of the chip and the power supply component are different. The length of the power supply link affects link impedance, and further affects current in the link. Consequently, a problem of current imbalance exists in power supply links corresponding to different power supply pins of the chip. In addition, an excessively long power supply link increases impedance, and makes it difficult to reduce parasitic inductance, resulting in a large rate of current change of the chip and causing voltage fluctuation of a power supply pin of the chip. Such transient voltage fluctuation causes problems in transient performance and power consumption of a processor, and the like.

In view of this, embodiments of this application provide a circuit board assembly that can be used in the foregoing electronic device. The circuit board assembly can resolve a problem that the power supply link of the foregoing circuit board is excessively long and current imbalance exists, to reduce impedance and inductance of a power supply link, reduce a circuit board loss and voltage fluctuation, and improve performance of the electronic device. The following specifically describes the circuit board assembly provided in embodiments of this application with reference to the accompanying drawings.

FIG. 2 is a side view of a circuit board assembly 300 according to an embodiment of this application. Refer to FIG. 2. In this embodiment of this application, the circuit board assembly 300 may include a first substrate 310, a second substrate 320, a chip 330, and a first power module 340. The first substrate 310 and the second substrate 320 are disposed opposite to each other and at an interval. The first substrate 310 includes a first surface 310a facing the second substrate 320. A power supply component 350 and a conductive member 360 may be disposed on the first surface 310a of the first substrate 310. The power supply component 350 is electrically connected to the conductive member 360. The second substrate 320 may be used as a carrier of the chip 330 and the first power module 340, and provide functions such as electrical connection, protection, support, heat dissipation, and assembly for the chip 330 and the first power module 340.

In some embodiments, the first substrate 310 may be a metal substrate, and heat generated when an electronic component disposed on the first substrate 310 operates may be transferred to the outside as soon as possible based on an excellent heat-conducting property of the metal substrate. The first substrate 310 includes a circuit board 311 and a metal plate 312 that are disposed in a stacked manner. A surface that is of the circuit board 311 and that is away from the metal plate 312 may be used as the first surface 310a of the first substrate 310. In this way, the power supply component 350 may be electrically connected to the conductive member 360 through a trace on the circuit board 311. The metal plate 312 may be made of metal with a high heat conductivity such as copper or aluminum.

In some other embodiments, the first substrate 310 may alternatively be a copper-clad ceramic substrate, and the copper-clad ceramic substrate can also achieve good heat dissipation effect for the electronic component disposed on the first substrate 310. For example, the first substrate 310 may be specifically a direct bonding copper direct bonding copper, DBC) ceramic substrate, an active metal brazing (active metal brazing, AMB) ceramic substrate, or the like. In this embodiment, a copper surface of the first substrate 310 may be used as the first surface 310a of the first substrate 310, and the power supply component 350 may be electrically connected to the conductive member 360 through a trace formed on the copper surface.

In this embodiment of this application, the power supply component 350 may be electrically connected to a power supply module of the electronic device. The power supply component 350 may be implemented in different forms based on different supply voltages of the power supply module. For example, when a supply voltage of the power supply module is 48 V, the power supply component 350 may include a power supply terminal 351 and a second power module 352. The power supply terminal 351 is electrically connected to the power supply module, an input end of the second power module 352 is electrically connected to the power supply terminal 351, an output end of the second power module 352 is electrically connected to the conductive member 360, and the second power module 352 is configured to regulate a voltage provided by the power supply terminal, and then transmit a voltage to the conductive member 360. For example, the second power module 352 may be configured to regulate the voltage of 48 V provided by the power supply module to a voltage of 12 V, and then output the voltage. For example, the second power module 352 may be an intermediate bus converter (intermediate bus converter, IBC) or the like.

Certainly, if a supply voltage of the power supply module is low, for example, 12 V, there may be no need to dispose the second power module 352 in the power supply component 350 for voltage conversion. In this case, the power supply component 350 is the power supply terminal 351.

In some possible embodiments, another electronic component, such as a capacitor 313 or an inductor (not shown in the figure), may be further disposed on the first surface 310a of the first substrate 310. The capacitor 313 or the inductor may be connected between the power supply component 350 and the conductive member 360, to perform filtering on an output voltage of the power supply component 350, and therefore improve stability of the output voltage of the power supply component 350.

Still refer to FIG. 2. In this embodiment of this application, the second substrate 320 may be a circuit board, and the second substrate 320 includes a first surface 320a and a second surface 320b that are disposed opposite to each other. The first surface 320a of the second substrate 320 is a surface facing away from the first substrate 310. Correspondingly, the second surface 320b of the second substrate 320 is a surface facing the first substrate 310. Alternatively, it may be understood as follows: The second surface 320b of the second substrate 320 and the first surface 310a of the first substrate 310 are disposed opposite to each other. In a specific implementation, the chip 330 may be disposed on the first surface 320a of the second substrate 320, the first power module 340 may be disposed on the second surface 320b of the second substrate 320, and the chip 330 and the first power module 340 may be disposed opposite to each other in a thickness direction of the second substrate 320.

As described above, the chip 330 may be any one or more of a GPU, a CPU, an ASIC, or an FPGA. The chip 330 may be fastened to the first surface 320a of the second substrate 320 through welding or the like.

The first power module 340 may be welded and fastened to the second surface 320b of the second substrate 320. There may be one or more first power modules 340. When there are a plurality of first power modules 340, the plurality of first power modules 340 may be arranged on the second surface 320b of the second substrate 320 in an ordered or unordered manner. Each first power module 340 includes an input terminal 341 and an output terminal 342. The input terminal 341 is located on a surface that is of the first power module 340 and that faces away from the second substrate 320, and the output terminal 342 is located on a surface that is of the first power module 340 and that faces the second substrate 320. In other words, the input terminal 341 and the output terminal 342 are respectively disposed on the two opposite surfaces of the first power module 340.

Still refer to FIG. 2. A pad is disposed at a position that is on the first surface 320a of the second substrate 320 and that corresponds to the output terminal 342 of the first power module 340, and the output terminal 342 is welded to the pad, to implement an electrical connection to the second substrate 320. In addition, a via hole 321 is provided at a position that is on the second substrate 320 and that corresponds to the pad, and the via hole 321 passes through the second substrate 320 in the thickness direction of the second substrate 320, so that the pad is electrically connected to the chip 330 disposed on the first surface 320a of the second substrate 320, to implement an electrical connection between the output terminal 342 and the chip 330.

It should be noted that, the via hole 321 may be provided in a manner of through hole, or may be provided in a manner of blind buried hole. A specific providing manner is not limited, and the figure is merely used as an example.

Based on the design in which the second surface 320b of the second substrate 320 is disposed opposite to the first surface 310a of the first substrate 310, the input terminal 341 of the first power module 340 is disposed toward the first surface 310a of the first substrate 310, so that the input terminal 341 can be electrically connected to the conductive member 360 disposed on the first surface 310a of the first substrate 310. In this way, the power supply component 350 may be electrically connected to the input terminal 341 of the first power module 340 through the conductive member 360. In addition, the conductive member 360 is properly disposed at a position on the first surface 310a of the first substrate 310, so that the input terminal of the first power module 340 can be opposite to the conductive member 360. In other words, a projection of the conductive member 360 on the second surface 320b of the second substrate 320 may cover or partially cover the input terminal 341 of the first power module 340, to reduce difficulty in an electrical connection between the input terminal 341 and the conductive member 360.

It can be learned from the foregoing descriptions that, a voltage output by the power supply component 350 is transmitted to the input terminal 341 of the first power module 340 through the conductive member 360, and after being processed by the first power module 340, the voltage is output to the chip 330 by the output terminal 342 of the first power module 340. Processing performed by the first power module 340 on the voltage includes: performing regulating and filtering on a voltage input by the input terminal 341, and outputting a voltage to the output terminal 342. In this way, the first power module 340 provides the chip 330 with a stable voltage that can match an operating voltage of the chip 330.

In this embodiment of this application, because the input terminal 341 and the output terminal 342 of the first power module 340 are located on two opposite surfaces of the first power module 340, a design of supplying power vertically to the chip is implemented. Compared with a horizontal power supply solution in which a power module and a chip are disposed on a same side of a substrate, the vertical power supply solution can avoid a problem of different lengths of power supply links to some extent, and can effectively shorten a path length of the power supply link, to reduce impedance and inductance of the power supply link, reduce a circuit board loss and voltage fluctuation, and help improve performance of the electronic device. It has been verified that impedance of the circuit board assembly 300 according to this embodiment of this application can be reduced by about 30% compared with impedance generated in the horizontal power supply solution, and a circuit board loss can also be reduced by about 30%.

Still refer to FIG. 2. In some embodiments, the conductive member 360 may be an elastic conductive member. When the first substrate 310 and the second substrate 320 are assembled, the conductive member 360 may abut against the input terminal 341 of the first power module 340, to implement an electrical connection between the conductive member 360 and the input terminal 341. With the use of such a design, difficulty in an operation of electrically connecting the conductive member 360 to the input terminal 341 can be reduced. In addition, when there are a plurality of first power modules 340, differences may exist in distances between the first power modules 340 and the first surface 310a of the first substrate 310 due to some inevitable tolerances between the plurality of first power modules 340, and in this case, a deformable characteristic of the conductive member 360 is used, so that conductive members 360 may be in different deformation states to compensate for the differences. This ensures that an input terminal 341 of each first power module 340 can be electrically connected to a corresponding conductive member 360 reliably, to improve reliability of the circuit board assembly 300.

A specific type of the conductive member 360 is not limited, for example, including but not limited to a spring plate, a spring ejector pin, a conductive adhesive layer, or the like.

In addition, the circuit board assembly 300 may further include a support member 370, and two ends of the support member 370 respectively abut against the first surface 310a of the first substrate 310 and the second surface 320b of the second substrate 320, so that the support member 370 is disposed between the first substrate 310 and the second substrate 320. The support member 370 avoids an electronic component (including the power supply component 350, the conductive member 360, and the like) on the first surface 310a of the first substrate 310 and an electronic component (including the first power module 340, and the like) on the second surface 320b of the second substrate 320. In this way, the interval between the first substrate 310 and the second substrate 320 may be limited by using the support member 370.

In a stacking direction of the first substrate 310 and the second substrate 320, a height of the support member 370 is less than a sum of a height of the conductive member 360 in an energy-release state and a height of the first power module 340. In this way, after the first substrate 310 and the second substrate 320 are assembled, the conductive member 360 can be in a compressed and energy-storage state, and a risk of over-compression of the conductive member 360 can be lowered through limiting of the support member 370. This improves reliability of a structure of the conductive member 360, and improves reliability of an electrical connection between the conductive member 360 and the input terminal 341 of the first power module 340.

In some embodiments, there may be one or more support members 370. When there are a plurality of support members 370, the plurality of support members 370 may be evenly distributed between the first substrate 310 and the second substrate 320, to improve support effect.

In this embodiment of this application, the first substrate 310 and the second substrate 320 may be fastened relative to each other by using a fastener (not shown in the figure). For example, the first substrate 310 is provided with a first installation hole, a second installation hole is provided at a position that is on the second substrate 320 and that is opposite to the first installation hole, and the fastener is installed in the first installation hole and the second installation hole. A nut matching the fastener may be fastened to a position that is on the first surface 320a of the second substrate 320 and that corresponds to the second installation hole, and an end part of the fastener may be locked in the nut, so that the first substrate 310 and the second substrate 320 are fastened.

In some other embodiments, the first substrate 310 and the second substrate 320 may alternatively be fastened through bonding. For example, a packaging adhesive may be filled between the first substrate 310 and the second substrate 320, so that the first substrate 310 and the second substrate 320 are fastened relative to each other by using the packaging adhesive.

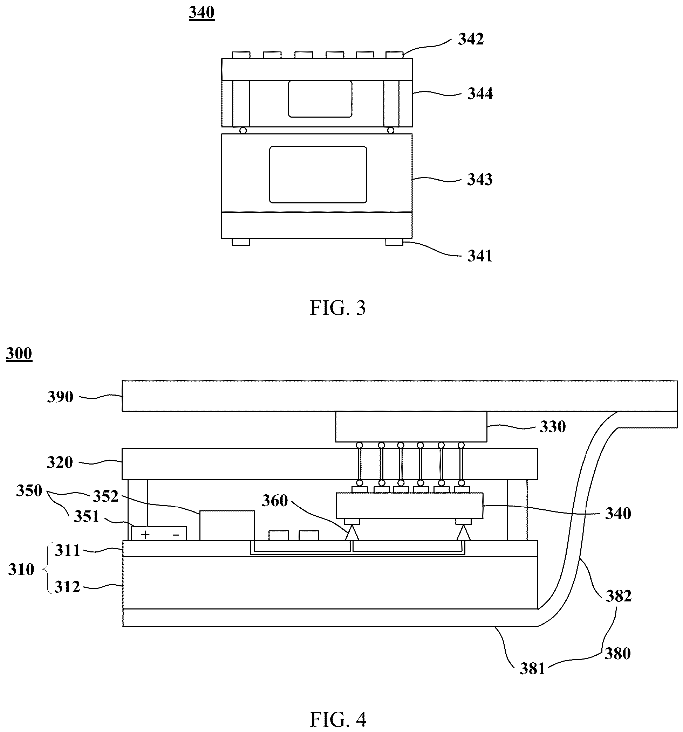

FIG. 3 is a schematic diagram of a structure of a first power module 340 according to an embodiment of this application. Refer to FIG. 3. In this embodiment of this application, the first power module 340 may include a voltage regulator module (voltage regulator module, VRM) 343 and one or more filter capacitors 344. The voltage regulator module 343 and the one or more filter capacitors 344 may be packaged into an integrated structure. For example, the voltage regulator module 343 and the filter capacitor 344 may be packaged into an integrated structure through ball grid array (ball grid array, BGA) packaging.

An input terminal of the voltage regulator module 343 is electrically connected to an input terminal 341 of the first power module 340, or an input terminal of the voltage regulator module 343 may be used as an input terminal 341 of the first power module 340. An output terminal of the filter capacitor 344 is electrically connected to an output terminal 342 of the first power module 340, or an output terminal of the filter capacitor 344 may be used as an output terminal 342 of the first power module 340. An output terminal of the voltage regulator module 343 is electrically connected to an input terminal of the filter capacitor 344. The voltage regulator module 343 is configured to regulate the voltage input by the input terminal 341, and then output a voltage to the filter capacitor 344, so that the regulated voltage can match the operating voltage of the chip 330. The filter capacitor 344 is configured to perform filtering on the voltage output by the voltage regulator module 343, and then output a voltage to the output terminal 342, to improve stability of the voltage output by the first power module 340 to the chip 330, and help improve operating reliability of the chip 330.

As described above, a voltage output by the power supply component 350 to the first power module 340 is approximately 12 V, and the operating voltage of the chip 330 is between 0.6 V and 1 V. For example, the operating voltage of the chip 330 is 0.9 V The voltage regulator module 343 may be configured to regulate the voltage of 12 V input by the input terminal 341 to 0.9 V, and then output the voltage of 0.9 V to the filter capacitor 344.

In addition, a specific type of the filter capacitor 344 is not limited, for example, including but not limited to a tantalum capacitor, a ceramic capacitor, or the like.

FIG. 4 is a schematic diagram of a structure of another circuit board assembly according to an embodiment of this application. Refer to FIG. 4. In this embodiment of this application, the circuit board assembly 300 may further include a first heat sink 380. The first heat sink 380 may be disposed on a surface that is of the first substrate 310 and that is away from the second substrate 320, and the first heat sink 380 is in heat-conducting contact with the first substrate 310. After heat generated when an electronic component on the first substrate 310 operates is transferred to the first substrate 310, the first substrate 310 may transfer the heat to the first heat sink 380, and the first heat sink 380 transfers the heat to the outside, to implement heat dissipation and cooling of the first substrate 310 and the electronic component disposed on the first substrate 310. In a specific implementation, the first heat sink 380 may be fastened, through welding, to the surface that is of the first substrate 310 and that is away from the second substrate 320.

In an embodiment, the first heat sink 380 may be a heat pipe. The heat pipe can dissipate heat for the first substrate 310, and implement a function of equalizing temperature, to improve temperature consistency between regions of the first substrate 310, and implement balanced heat dissipation effect for the first substrate 310 and the electronic component disposed on the first substrate 310. The heat pipe may include an evaporation section 381 and a condensation section 382. The evaporation section 381 is in heat-conducting contact with the first substrate 310, so that heat of the first substrate 310 is absorbed by using a cooling medium in the evaporation section 381, to implement heat dissipation and cooling of the first substrate 310. In this case, the cooling medium in the evaporation section 381 is evaporated into a gas. The gaseous cooling medium flows to the condensation section 382 of the heat pipe, releases heat and condenses into a liquid in the condensation section 382, and then returns to the evaporation section 381. In this way, continuous heat dissipation and temperature equalizing can be implemented for the first substrate 310.

In some other embodiments, the first heat sink 380 may alternatively be an air-cooled heat sink. In this case, fins may be disposed on a surface that is of the first heat sink 380 and that faces away from the first substrate 310. In this way, an outer surface area of the first heat sink 380 can be effectively increased, improving efficiency in heat exchange between the first heat sink 380 and external air, and further improving a heat dissipation capability of the first heat sink 380.

Still refer to FIG. 4. The circuit board assembly 300 may further include a second heat sink 390. The second heat sink 390 may be disposed on a surface that is of the chip 330 and that is away from the second substrate 320, and the second heat sink 390 is in heat-conducting contact with the chip 330. In this way, heat generated in an operating process of the chip 330 may be transferred to the second heat sink 390, and transferred to the outside through the second heat sink 390, to implement heat dissipation and cooling of the chip 330.

In addition, a heat-conducting medium may be disposed between the chip 330 and the second heat sink 390, and the heat-conducting medium may fill a micro gap generated due to an uneven surface when the chip 330 is in contact with the second heat sink 390, to reduce thermal resistance of heat transfer, and help improve heat dissipation effect of the chip 330.

In an embodiment, the second heat sink 390 may be a liquid-cooled plate. The liquid-cooled plate can continuously transfer, through circulation of a cooling medium inside the liquid-cooled plate, heat generated by the chip 330 to the outside, to implement continuous heat dissipation of the chip 330.

It should be noted that, when the second heat sink 390 is the liquid-cooled plate and the first heat sink 380 is the heat pipe, an edge of the second heat sink 390 may be disposed outside the second substrate 320, and the condensation section 382 of the first heat sink 380 may be bent in a direction toward the second heat sink 390 relative to the evaporation section 381 of the first heat sink 380, so that the condensation section 382 of the first heat sink 380 is in heat-conducting contact with a part of the second heat sink 390 outside the second substrate 320, to quickly cool the cooling medium in the condensation section 382 of the first heat sink 380 by using the second heat sink 390.

Certainly, in some other embodiments, the second heat sink 390 may alternatively be an air-cooled heat sink. In this case, fins may be disposed on a surface that is of the second heat sink 390 and that faces away from the second substrate 320. In this way, an outer surface area of the second heat sink 390 can be effectively increased, improving efficiency in heat exchange between the second heat sink 390 and external air, and further improving a heat dissipation capability of the second heat sink 390.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board assembly, comprising a first substrate, a second substrate, a chip, and a first power module, wherein the first substrate and the second substrate are disposed opposite to each other and at an interval;
the first substrate comprises a first surface facing the second substrate, a power supply component and a conductive member are disposed on the first surface of the first substrate, and the power supply component is electrically connected to the conductive member;
the second substrate comprises a first surface facing away from the first substrate and a second surface facing the first substrate;
the chip is disposed on the first surface of the second substrate; and
the first power module is disposed on the second surface of the second substrate, an input terminal is disposed on a surface that is of the first power module and that faces the first substrate, the input terminal is electrically connected to the conductive member, an output terminal is disposed on a surface that is of the first power module and that faces the second substrate, the output terminal is electrically connected to the chip, and the first power module is configured to regulate a voltage input by the input terminal, and then output a voltage to the output terminal.

2. The circuit board assembly according to claim 1, wherein the first power module comprises a voltage regulator module and at least one filter capacitor, and the voltage regulator module and the at least one filter capacitor are packaged into an integrated structure;
the voltage regulator module is configured to regulate the voltage input by the input terminal, and then output a voltage to the filter capacitor; and
the filter capacitor is configured to perform filtering on the voltage output by the voltage regulator, and then output a voltage to the output terminal.

3. The circuit board assembly according to claim 1 or 2, wherein the conductive member is an elastic conductive member, and the conductive member abuts against the input terminal.

4. The circuit board assembly according to claim 3, wherein the circuit board assembly further comprises a support member, the support member is disposed between the first substrate and the second substrate, and a height of the support member is less than a sum of a height of the conductive member in an energy-release state and a height of the first power module.

5. The circuit board assembly according to claim 3 or 4, wherein the first substrate is provided with a first installation hole, a second installation hole is provided at a position that is on the second substrate and that is opposite to the first installation hole, and the first substrate and the second substrate are fastened relative to each other through a fastener that is installed in the first installation hole and the second installation hole.

6. The circuit board assembly according to any one of claims 1 to 5, wherein the power supply component comprises a power supply terminal and a second power module, an input end of the second power module is electrically connected to the power supply terminal, an output end of the second power module is electrically connected to the conductive member, and the second power module is configured to regulate a voltage input by the power supply terminal.

7. The circuit board assembly according to any one of claims 1 to 5, wherein the power supply component is the power supply terminal, and the power supply terminal is electrically connected to the conductive member.

8. The circuit board assembly according to any one of claims 1 to 7, wherein the first substrate comprises a circuit board and a metal plate, the circuit board and the metal plate are disposed in a stacked manner, and a surface that is of the circuit board and that is away from the metal plate forms the first surface of the first substrate.

9. The circuit board assembly according to any one of claims 1 to 8, wherein the circuit board assembly further comprises a first heat sink, and the first heat sink is disposed on a surface that is of the first substrate and that is away from the second substrate.

10. The circuit board assembly according to any one of claims 1 to 9, wherein the circuit board assembly further comprises a second heat sink, and the second heat sink is disposed on a surface that is of the chip and that is away from the second substrate.

11. An electronic device, comprising a housing and the circuit board assembly according to any one of claims 1 to 10, wherein the circuit board assembly is disposed in the housing.
